# EUROPEAN PATENT APPLICATION

(11) **EP 4 137 950 A1**
(43) Date of publication of application: **22.02.2023**
(21) Application number: 22190988.0
(22) Date of filing: 18.08.2022
(51) Int. Cl.: G06F 11/36, G06F 30/20, G09B 9/042

(54) **METHODS AND SYSTEMS FOR PROVIDING RESULTS OF AN AUTONOMOUS VEHICLE SIMULATION**

(30) Priority: 18.08.2021 US 202117405259
(71) Applicant: Argo AI, LLC, Pittsburgh, PA 15222 (US)
(72) Inventor: CHAN, Tsz Kiu, Pittsburgh, 15222 (US)
(74) Representative: Hofstetter, Schurack & Partner

(57) **Abstract**

Systems providing a comparison of results of simulations of operation of a simulated autonomous vehicle may include a processor to: perform a first simulation of operation of a simulated autonomous vehicle based on first autonomous vehicle control code, receive second autonomous vehicle control code that includes a second version of software code associated with controlling operations of the simulated autonomous vehicle, the second version including a modification of a first version of software code associated with controlling operations of the simulated autonomous vehicle, perform a second simulation of operation of the simulated autonomous vehicle based on the second autonomous vehicle control code, and display an indication that second values of one or more metrics that resulted from the second simulation are different from one or more first values of the one or more metrics that resulted from the first simulation. Methods, computer program products, and autonomous vehicles are also disclosed.

## Description

### CROSS REFERENCE TO RELATED APPLICATION(S)

This application claims priority to United States Patent Application No. 17/405,259, filed on August 18, 2021, the entire contents of which are hereby incorporated by reference in their entirety.

### BACKGROUND

### 1. Field

This disclosure relates generally to aspects of autonomous vehicles and, in some non-limiting embodiments, to providing a comparison of results of simulations of operation of a simulated autonomous vehicle.

### 2. Technical Considerations

An autonomous vehicle (e.g., a driverless car, a driverless auto, a self-driving car, a robotic car, etc.) is a vehicle that is capable of sensing an environment of the vehicle and traveling (e.g., navigating, moving, etc.) in the environment without manual input from an individual. An autonomous vehicle uses a variety of techniques to detect the environment of the autonomous vehicle, such as radar, laser light, Global Positioning System (GPS), odometry, and/or computer vision. In some instances, an autonomous vehicle uses a control system to interpret information received from one or more sensors, to identify a route for traveling, to identify an obstacle in a route, and to identify relevant traffic signs associated with a route.

### SUMMARY

Provided are systems, methods, products, apparatuses, and/or devices for providing a comparison of results of simulations of operation of a simulated autonomous vehicle.

According to some non-limiting embodiments, provided is a system comprising a memory and at least one processor coupled to the memory and configured to: receive first autonomous vehicle control code, wherein the first autonomous vehicle control code comprises a first version of software code associated with controlling operations of a simulated autonomous vehicle; perform a first simulation of operation of the simulated autonomous vehicle based on the first autonomous vehicle control code, wherein the first simulation of operation is associated with one or more metrics that measure performance of the simulated autonomous vehicle; receive second autonomous vehicle control code, wherein the second autonomous vehicle control code comprises a second version of software code associated with controlling operations of the simulated autonomous vehicle, wherein the second version of software code associated with controlling operations of the simulated autonomous vehicle comprises a modification of the first version of software code associated with controlling operations of the simulated autonomous vehicle; perform a second simulation of operation of the simulated autonomous vehicle based on the second autonomous vehicle control code, wherein the second simulation of operation is associated with the one or more metrics that measure performance of the simulated autonomous vehicle; and display an indication, in a user interface, that one or more second values of the one or more metrics that resulted from the second simulation of operation are different from the one or more first values of the one or more metrics that resulted from the first simulation of operation.

According to some non-limiting embodiments, provided is a computer program product comprising at least one non-transitory computer-readable medium comprising one or more instructions that, when executed by at least one processor, cause the at least one processor to: receive first autonomous vehicle control code, wherein the first autonomous vehicle control code comprises a first version of software code associated with controlling operations of a simulated autonomous vehicle; perform a first simulation of operation of the simulated autonomous vehicle based on the first autonomous vehicle control code, wherein the first simulation of operation is associated with one or more metrics that measure performance of the simulated autonomous vehicle; receive second autonomous vehicle control code, wherein the second autonomous vehicle control code comprises a second version of software code associated with controlling operations of the simulated autonomous vehicle, wherein the second version of software code associated with controlling operations of the simulated autonomous vehicle comprises a modification of the first version of software code associated with controlling operations of the simulated autonomous vehicle; perform a second simulation of operation of the simulated autonomous vehicle based on the second autonomous vehicle control code, wherein the second simulation of operation is associated with the one or more metrics that measure performance of the simulated autonomous vehicle; and display an indication, in a user interface, that one or more second values of the one or more metrics that resulted from the second simulation of operation are different from the one or more first values of the one or more metrics that resulted from the first simulation of operation.

According to some non-limiting embodiments, provided is a method comprising: performing, with at least one processor, a first simulation of operation of the simulated autonomous vehicle based on the first autonomous vehicle control code, wherein the first simulation of operation is associated with one or more metrics that measure performance of the simulated autonomous vehicle; receiving, with the at least one processor, second autonomous vehicle control code, wherein the second autonomous vehicle control code comprises a second version of software code associated with controlling operations of the simulated autonomous vehicle, wherein the second version of software code associated with controlling operations of the simulated autonomous vehicle comprises a modification of the first version of software code associated with controlling operations of the simulated autonomous vehicle; performing, with the at least one processor, a second simulation of operation of the simulated autonomous vehicle based on the second autonomous vehicle control code, wherein the second simulation of operation is associated with the one or more metrics that measure performance of the simulated autonomous vehicle; and displaying, with the at least one processor, an indication, in a user interface, that one or more second values of the one or more metrics that resulted from the second simulation of operation are different from the one or more first values of the one or more metrics that resulted from the first simulation of operation.

Further embodiments are set forth in the following numbered clauses:
Clause 1: A system comprising: a memory; and at least one processor coupled to the memory and configured to: receive first autonomous vehicle control code, wherein the first autonomous vehicle control code comprises a first version of software code associated with controlling operations of a simulated autonomous vehicle; perform a first simulation of operation of the simulated autonomous vehicle based on the first autonomous vehicle control code, wherein the first simulation of operation is associated with one or more metrics that measure performance of the simulated autonomous vehicle; receive second autonomous vehicle control code, wherein the second autonomous vehicle control code comprises a second version of software code associated with controlling operations of the simulated autonomous vehicle, wherein the second version of software code associated with controlling operations of the simulated autonomous vehicle comprises a modification of the first version of software code associated with controlling operations of the simulated autonomous vehicle; perform a second simulation of operation of the simulated autonomous vehicle based on the second autonomous vehicle control code, wherein the second simulation of operation is associated with the one or more metrics that measure performance of the simulated autonomous vehicle; and display an indication, in a user interface, that one or more second values of the one or more metrics that resulted from the second simulation of operation are different from the one or more first values of the one or more metrics that resulted from the first simulation of operation.
Clause 2: The system of clause 1, wherein the at least one processor is further configured to: display the one or more first values of the one or more metrics that resulted from the first simulation of operation in the user interface; and display one or more second values of the one or more metrics that resulted from the second simulation of operation in the user interface.
Clause 3: The system of clauses 1 or 2, wherein the at least one processor is further configured to: determine whether the one or more second values of the one or more metrics that resulted from the second simulation of operation satisfy one or more thresholds; and display an indication, in the user interface, that the one or more second values of the one or more metrics that resulted from the second simulation of operation satisfy the one or more thresholds based on determining that the one or more second values of the one or more metrics that resulted from the second simulation of operation satisfy the one or more thresholds.
Clause 4: The system of any of clauses 1-3, wherein the at least one processor is further configured to: display one or more maximum values of the one or more metrics that resulted from the second simulation of operation in the user interface.
Clause 5: The system of any of clauses 1-4, wherein the one or more metrics that measure performance of the simulated autonomous vehicle comprise: a metric associated with a minimum distance between the simulated autonomous vehicle and an actor experienced during a simulation of operation; a metric associated with a number of halt events experienced by the simulated autonomous vehicle during a simulation of operation; a metric associated with an amount of longitudinal deceleration experienced by the simulated autonomous vehicle during a simulation of operation; a metric associated with an amount of longitudinal negative jerk experienced by the simulated autonomous vehicle during a simulation of operation; a metric associated with an amount of lateral acceleration experienced by the simulated autonomous vehicle during a simulation of operation; a metric associated with an amount of lateral jerk experienced by the simulated autonomous vehicle during a simulation of operation; a metric associated with a number of times the simulated autonomous vehicle planned to stop; a metric associated with a number of times the simulated autonomous vehicle planned to change a trajectory; or any combination thereof.
Clause 6: The system of any of clauses 1-5, wherein the at least one processor is further configured to: display an amount by which the one or more second values of the one or more metrics are different than the one or more first values of the one or more metrics.
Clause 7: The system of any of clauses 1-6 wherein the at least one processor is further configured to: provide operational code to an autonomous vehicle for operating the autonomous vehicle in a real environment, wherein the operational code is based on the second autonomous vehicle control code; and operate the autonomous vehicle in the real environment based on the operational code.
Clause 8: The system of any of clauses 1-7, wherein the at least one processor is further configured to: perform a plurality of additional simulations of operation of the simulated autonomous vehicle, wherein each additional simulation of operation is performed based on an additional version of software code associated with controlling operations of the simulated autonomous vehicle; display, in the user interface, a trend graph of values of the one or more metrics that resulted from the plurality of additional simulations of operation of the simulated autonomous vehicle; and display an indication of the one or more second values of the one or more metrics that resulted from the second autonomous vehicle control code in comparison to the trend graph.
Clause 9: A computer program product comprising at least one non-transitory computer-readable medium comprising one or more instructions that, when executed by at least one processor, cause the at least one processor to: receive first autonomous vehicle control code, wherein the first autonomous vehicle control code comprises a first version of software code associated with controlling operations of a simulated autonomous vehicle; perform a first simulation of operation of the simulated autonomous vehicle based on the first autonomous vehicle control code, wherein the first simulation of operation is associated with one or more metrics that measure performance of the simulated autonomous vehicle; receive second autonomous vehicle control code, wherein the second autonomous vehicle control code comprises a second version of software code associated with controlling operations of the simulated autonomous vehicle, wherein the second version of software code associated with controlling operations of the simulated autonomous vehicle comprises a modification of the first version of software code associated with controlling operations of the simulated autonomous vehicle; perform a second simulation of operation of the simulated autonomous vehicle based on the second autonomous vehicle control code, wherein the second simulation of operation is associated with the one or more metrics that measure performance of the simulated autonomous vehicle; and display an indication, in a user interface, that one or more second values of the one or more metrics that resulted from the second simulation of operation are different from the one or more first values of the one or more metrics that resulted from the first simulation of operation.
Clause 10: The computer program product of clause 9, wherein the one or more instructions further cause the at least one processor to: display the one or more first values of the one or more metrics that resulted from the first simulation of operation in the user interface; and display one or more second values of the one or more metrics that resulted from the second simulation of operation in the user interface.
Clause 11: The computer program product of clauses 9 or 10, wherein the one or more instructions further cause the at least one processor to: determine whether the one or more second values of the one or more metrics that resulted from the second simulation of operation satisfy one or more thresholds; and display an indication, in the user interface, that the one or more second values of the one or more metrics that resulted from the second simulation of operation satisfy the one or more thresholds based on determining that the one or more second values of the one or more metrics that resulted from the second simulation of operation satisfy the one or more thresholds.
Clause 12: The computer program product of any of clauses 9-11, wherein the one or more instructions further cause the at least one processor to: display one or more maximum values of the one or more metrics that resulted from the second simulation of operation in the user interface.
Clause 13: The computer program product of any of clauses 9-12, wherein the one or more metrics that measure performance of the simulated autonomous vehicle comprise: a metric associated with a minimum distance between the simulated autonomous vehicle and an actor experienced during a simulation of operation; a metric associated with a number of halt events experienced by the simulated autonomous vehicle during a simulation of operation; a metric associated with an amount of longitudinal deceleration experienced by the simulated autonomous vehicle during a simulation of operation; a metric associated with an amount of longitudinal negative jerk experienced by the simulated autonomous vehicle during a simulation of operation; a metric associated with an amount of lateral acceleration experienced by the simulated autonomous vehicle during a simulation of operation; a metric associated with an amount of lateral jerk experienced by the simulated autonomous vehicle during a simulation of operation; a metric associated with a number of times the simulated autonomous vehicle planned to stop; a metric associated with a number of times the simulated autonomous vehicle planned to change a trajectory; or any combination thereof.
Clause 14: The computer program product of any of clauses 9-13, wherein the one or more instructions further cause the at least one processor to: provide operational code to an autonomous vehicle for operating the autonomous vehicle in a real environment, wherein the operational code is based on the second autonomous vehicle control code; and operate the autonomous vehicle in the real environment based on the operational code.
Clause 15: The computer program product of any of clauses 9-14, wherein the one or more instructions further cause the at least one processor to: perform a plurality of additional simulations of operation of the simulated autonomous vehicle, wherein each additional simulation of operation is performed based on an additional version of software code associated with controlling operations of the simulated autonomous vehicle; display, in the user interface, a trend graph of values of the one or more metrics that resulted from the plurality of additional simulations of operation of the simulated autonomous vehicle; and display an indication of the one or more second values of the one or more metrics that resulted from the second autonomous vehicle control code in comparison to the trend graph.
Clause 16: A method, comprising: performing, with at least one processor, a first simulation of operation of the simulated autonomous vehicle based on the first autonomous vehicle control code, wherein the first simulation of operation is associated with one or more metrics that measure performance of the simulated autonomous vehicle; receiving, with the at least one processor, second autonomous vehicle control code, wherein the second autonomous vehicle control code comprises a second version of software code associated with controlling operations of the simulated autonomous vehicle, wherein the second version of software code associated with controlling operations of the simulated autonomous vehicle comprises a modification of the first version of software code associated with controlling operations of the simulated autonomous vehicle; performing, with the at least one processor, a second simulation of operation of the simulated autonomous vehicle based on the second autonomous vehicle control code, wherein the second simulation of operation is associated with the one or more metrics that measure performance of the simulated autonomous vehicle; and displaying, with the at least one processor, an indication, in a user interface, that one or more second values of the one or more metrics that resulted from the second simulation of operation are different from the one or more first values of the one or more metrics that resulted from the first simulation of operation.
Clause 17: The method of clause 16, further comprising: determining whether the one or more second values of the one or more metrics that resulted from the second simulation of operation satisfy one or more thresholds; and displaying an indication, in the user interface, that the one or more second values of the one or more metrics that resulted from the second simulation of operation satisfy the one or more thresholds based on determining that the one or more second values of the one or more metrics that resulted from the second simulation of operation satisfy the one or more thresholds.
Clause 18: The method of clauses 16 or 17, wherein the one or more metrics that measure performance of the simulated autonomous vehicle comprise: a metric associated with a minimum distance between the simulated autonomous vehicle and an actor experienced during a simulation of operation; a metric associated with a number of halt events experienced by the simulated autonomous vehicle during a simulation of operation; a metric associated with an amount of longitudinal deceleration experienced by the simulated autonomous vehicle during a simulation of operation; a metric associated with an amount of longitudinal negative jerk experienced by the simulated autonomous vehicle during a simulation of operation; a metric associated with an amount of lateral acceleration experienced by the simulated autonomous vehicle during a simulation of operation; a metric associated with an amount of lateral jerk experienced by the simulated autonomous vehicle during a simulation of operation; a metric associated with a number of times the simulated autonomous vehicle planned to stop; a metric associated with a number of times the simulated autonomous vehicle planned to change a trajectory; or any combination thereof.
Clause 19: The method of any of clauses 16-18, further comprising: providing operational code to an autonomous vehicle for operating the autonomous vehicle in a real environment, wherein the operational code is based on the second autonomous vehicle control code; and operating the autonomous vehicle in the real environment based on the operational code.
Clause 20: The method of any of clauses 16-19, further comprising: performing a plurality of additional simulations of operation of the simulated autonomous vehicle before performing the second simulation, wherein each additional simulation of operation is performed based on an additional version of software code associated with controlling operations of the simulated autonomous vehicle; displaying, in the user interface, a trend graph of values of the one or more metrics that resulted from the plurality of additional simulations of operation of the simulated autonomous vehicle; and displaying an indication of the one or more second values of the one or more metrics that resulted from the second autonomous vehicle control code in comparison to the trend graph.

### BRIEF DESCRIPTION OF THE DRAWINGS

Additional advantages and details are explained in greater detail below with reference to the exemplary embodiments that are illustrated in the accompanying schematic figures, in which:
FIG. 1 is a diagram of a non-limiting embodiment of an environment in which systems, methods, and/or computer program products, described herein, may be implemented;
FIG. 2 is an diagram of a non-limiting embodiment of an architecture for an autonomous vehicle;
FIG. 3 is an diagram of a non-limiting embodiment of an architecture for a LiDAR system;
FIG. 4 is an diagram of a non-limiting embodiment of a computing device;
FIG. 5 is a flowchart of a non-limiting embodiment of a process for providing a comparison of results of simulations of operation of a simulated autonomous vehicle;
FIGS. 6A-6E are diagrams of a non-limiting embodiment of an implementation of a process for providing a comparison of results of simulations of operation of a simulated autonomous vehicle; and
FIG. 7 is a diagram of a non-limiting embodiment of a trend graph of results of simulations of operation of a simulated autonomous vehicle.

### DESCRIPTION

It is to be understood that the present disclosure may assume various alternative variations and step sequences, except where expressly specified to the contrary. It is also to be understood that the specific devices and processes illustrated in the attached drawings, and described in the following specification, are simply exemplary and non-limiting embodiments. Hence, specific dimensions and other physical characteristics related to the embodiments disclosed herein are not to be considered as limiting.

No aspect, component, element, structure, act, step, function, instruction, and/or the like used herein should be construed as critical or essential unless explicitly described as such. Also, as used herein, the articles "a" and "an" are intended to include one or more items, and may be used interchangeably with "one or more" and "at least one." As used in the specification and the claims, the singular form of "a," "an," and "the" include plural referents, such as unless the context clearly dictates otherwise. Additionally, as used herein, the terms "set" and "group" are intended to include one or more items (e.g., related items, unrelated items, a combination of related and unrelated items, etc.) and may be used interchangeably with "one or more" or "at least one." Where only one item is intended, the term "one" or similar language is used. Also, as used herein, the terms "has," "have," "having," or the like are intended to be open-ended terms. Further, the phrase "based on" is intended to mean "based at least partially on" unless explicitly stated otherwise. Further, the phrase "based on" is intended to mean "based at least partially on" unless explicitly stated otherwise. Further, the phrase "based on" may mean "in response to" and be indicative of a condition for automatically triggering a specified operation of an electronic device (e.g., a processor, a computing device, etc.) as appropriately referred to herein.

As used herein, the term "communication" may refer to the reception, receipt, transmission, transfer, provision, and/or the like, of data (e.g., information, signals, messages, instructions, commands, and/or the like). For one unit (e.g., a device, a system, a component of a device or system, combinations thereof, and/or the like) to be in communication with another unit means that the one unit is able to directly or indirectly receive information from and/or transmit information to the other unit. This may refer to a direct or indirect connection (e.g., a direct communication connection, an indirect communication connection, and/or the like) that is wired and/or wireless in nature. Additionally, two units may be in communication with each other even though the information transmitted may be modified, processed, relayed, and/or routed between the first and second unit. For example, a first unit may be in communication with a second unit even though the first unit passively receives information and does not actively transmit information to the second unit. As another example, a first unit may be in communication with a second unit if at least one intermediary unit processes information received from the first unit and communicates the processed information to the second unit.

It will be apparent that systems and/or methods, described herein, can be implemented in different forms of hardware, software, or a combination of hardware and software. The actual specialized control hardware or software code used to implement these systems and/or methods is not limiting of the implementations. Thus, the operation and behavior of the systems and/or methods are described herein without reference to specific software code, it being understood that software and hardware can be designed to implement the systems and/or methods based on the description herein.

Some non-limiting embodiments are described herein in connection with thresholds. As used herein, satisfying a threshold may refer to a value being greater than the threshold, more than the threshold, higher than the threshold, greater than or equal to the threshold, less than the threshold, fewer than the threshold, lower than the threshold, less than or equal to the threshold, equal to the threshold, etc.

The term "vehicle" refers to any moving form of conveyance that is capable of carrying either one or more human occupants and/or cargo and is powered by any form of energy. The term "vehicle" includes, but is not limited to, cars, trucks, vans, trains, autonomous vehicles, aircraft, aerial drones, and the like. An "autonomous vehicle" is a vehicle having a processor, programming instructions, and drivetrain components that are controllable by the processor without requiring a human operator. An autonomous vehicle may be fully autonomous in that the autonomous vehicle does not require a human operator for most or all driving conditions and functions. In some non-limiting embodiments, the autonomous vehicle may be semi-autonomous in that a human operator may be required in certain conditions or for certain operations, or that a human operator may override the vehicle's autonomous system and may take control of the vehicle.

As used herein, the term "computing device" may refer to one or more electronic devices configured to process data. A computing device may, in some examples, include the necessary components to receive, process, and output data, such as a processor, a display, a memory, an input device, a network interface, and/or the like. In some non-limiting embodiments, a computing device may be a mobile device. As an example, a mobile device may include a cellular phone (e.g., a smartphone or standard cellular phone), a portable computer (e.g., a tablet), a wearable device (e.g., watches, glasses, lenses, clothing, and/or the like), a personal digital assistant (PDA), and/or other like devices. In some non-limiting embodiments, a computing device may be a computer that is not portable (e.g., is not a mobile device), such as a desktop computer (e.g., a personal computer).

As used herein, the term "server" and/or "processor" may refer to or include one or more computing devices that are operated by or facilitate communication and processing for multiple parties in a network environment, such as the Internet, although it will be appreciated that communication may be facilitated over one or more public or private network environments and that various other arrangements are possible. Further, multiple computing devices (e.g., servers, mobile devices, desktop computers, etc.) directly or indirectly communicating in the network environment may constitute a "system." Reference to "a server" or "a processor," as used herein, may refer to a previously-recited server and/or processor that is recited as performing a previous step or function, a different server and/or processor, and/or a combination of servers and/or processors. For example, as used in the specification and the claims, a first server and/or a first processor that is recited as performing a first step or function may refer to the same or different server and/or a processor recited as performing a second step or function.

As used herein, the term "user interface" or "graphical user interface" may refer to a display generated by a computing device, with which a user may interact, either directly or indirectly (e.g., through a keyboard, mouse, touchscreen, etc.).

Simulations of operations of an autonomous vehicle may be performed to determine whether the autonomous vehicle will operate in a desired manner in a specific situation. The simulations may be performed based on software code associated with controlling operations of a simulated autonomous vehicle in a simulated environment. Performing simulations of operations may provide for safer development of an autonomous vehicle, as compared to real-world testing of the autonomous vehicle. Further, operational code for operating the autonomous vehicle in a real environment may be developed with less time and fewer resources. As part of performing simulations of operations, multiple individuals may develop software code (e.g., different versions of software code) associated with controlling operations of the simulated autonomous vehicle in the simulated environment simultaneously. In some instances, one or more simulations may be run on the software code developed by each individual in a parallel manner. The one or more simulations may be associated with stages of development, where each stage of development may test specific aspects of operation of the simulated autonomous vehicle when a simulation is performed based on the software code.

In some instances, versions of the software code developed by each individual may be merged into a corpus of software code according to a stage of development after simulations are performed based on the software code. Ultimately, the corpus of software code may be provided to an autonomous vehicle as operational software code for operating the autonomous vehicle in a real environment.

However, problems may be encountered when different versions of software code are merged. For example, a simulation may be performed based on one or more versions of the software code that results in an initial value of a metric that measures performance of a simulated autonomous vehicle during the simulation. When the one or more versions of the software code are merged with other versions of the software code, the simulation may be performed again based on the corpus of software code. The simulation may result in a new value of the metric that is different from the initial value of the metric. In some instances, the new value of the metric may indicate an unacceptable operation of the simulated autonomous vehicle during the simulation. It may not be possible to determine what aspect of the versions of the software code, which are merged to form the corpus of software code, caused the value of the metric to change from the initial value to the new value. This may result in additional simulations being performed, as well as additional versions of software code being developed to provide operational code that is acceptable for operating an autonomous vehicle in a real environment.

The present disclosure provides systems, methods, and computer program products that provide a comparison of results of simulations of operation of a simulated autonomous vehicle. In some non-limiting embodiments, the present disclosure includes an autonomous vehicle simulation system to perform a first simulation of operation of a simulated autonomous vehicle based on first autonomous vehicle control code, where the first autonomous vehicle control code includes a first version of software code associated with controlling operations of an autonomous vehicle, where the first simulation of operation is associated with one or more metrics that measure performance of the simulated autonomous vehicle, receive second autonomous vehicle control code, where the second autonomous vehicle control code is a second version of software code associated with controlling operations of the simulated autonomous vehicle, wherein the second version of software code associated with controlling operations of the simulated autonomous vehicle comprises a modification of the first version of software code associated with controlling operations of the simulated autonomous vehicle, perform a second simulation of operation of the simulated autonomous vehicle based on the second autonomous vehicle control code, wherein the second simulation of operation is associated with the one or more metrics that measure performance of the simulated autonomous vehicle, and display an indication, in a user interface, that one or more second values of the one or more metrics that resulted from the second autonomous vehicle control code are different from the one or more first values of the one or more metrics that resulted from the first autonomous vehicle control code.

In some non-limiting embodiments, the autonomous vehicle simulation system is further configured to display the one or more first values of the one or more metrics that resulted from the first simulation of operation in the user interface and display one or more second values of the one or more metrics that resulted from the second simulation of operation in the user interface. In some non-limiting embodiments, the autonomous vehicle simulation system is further configured to determine whether the one or more second values of the one or more metrics that resulted from the second simulation of operation satisfy the one or more thresholds and display an indication, in the user interface, that the one or more second values of the one or more metrics that resulted from the second simulation operation satisfy the one or more thresholds.

In some non-limiting embodiments, the autonomous vehicle simulation system is further configured to display one or more maximum values of the one or more metrics that resulted from the second autonomous vehicle control code in the user interface. In some non-limiting embodiments, the one or more metrics that measure performance of the simulated autonomous vehicle comprise a metric associated with a minimum distance between the simulated autonomous vehicle and an actor experienced during a simulation of operation, a metric associated with a number of halt events experienced by the simulated autonomous vehicle during a simulation of operation, a metric associated with an amount of longitudinal deceleration experienced by the simulated autonomous vehicle during a simulation of operation, a metric associated with an amount of longitudinal negative jerk experienced by the simulated autonomous vehicle during a simulation of operation, a metric associated with an amount of lateral acceleration experienced by the simulated autonomous vehicle during a simulation of operation, a metric associated with an amount of lateral jerk experienced by the simulated autonomous vehicle during a simulation of operation, a metric associated with a number of times the simulated autonomous vehicle planned to stop, a metric associated with a number of times the simulated autonomous vehicle planned to change a trajectory, or any combination thereof.

In some non-limiting embodiments, the autonomous vehicle simulation system is further configured to display an amount by which the one or more second values of the one or more metrics are different than the one or more first values of the one or more metrics. In some non-limiting embodiments, the autonomous vehicle simulation system is further configured to provide operational code to an autonomous vehicle for operating the autonomous vehicle in a real environment, wherein the operational code is based on the second autonomous vehicle control code and operate the autonomous vehicle in the real environment based on the operational code. In some non-limiting embodiments, the autonomous vehicle simulation system is further configured to perform a plurality of additional simulations of operation of the simulated autonomous vehicle, where each additional simulation of operation is performed based on an additional version of software code associated with controlling operations of the simulated autonomous vehicle, display, in the user interface, a trend graph of values of the one or more metrics that resulted from the plurality of additional simulations of operation of the simulated autonomous vehicle and display an indication of the one or more second values of the one or more metrics that resulted from the second autonomous vehicle control code in comparison to the trend graph.

In this way, the autonomous vehicle simulation system may provide a user with a way to readily compare results of simulations and determine what aspects of a version of software code associated with controlling operations of the simulated autonomous vehicle caused changes regarding a value of the metric that measure performance of a simulated autonomous vehicle. In this way, the autonomous vehicle simulation system may reduce the amount of time and resources necessary for developing the operational code for operating an autonomous vehicle in a real environment since the number of simulations of operations may be reduced, along with the required number of versions of software code to be tested.

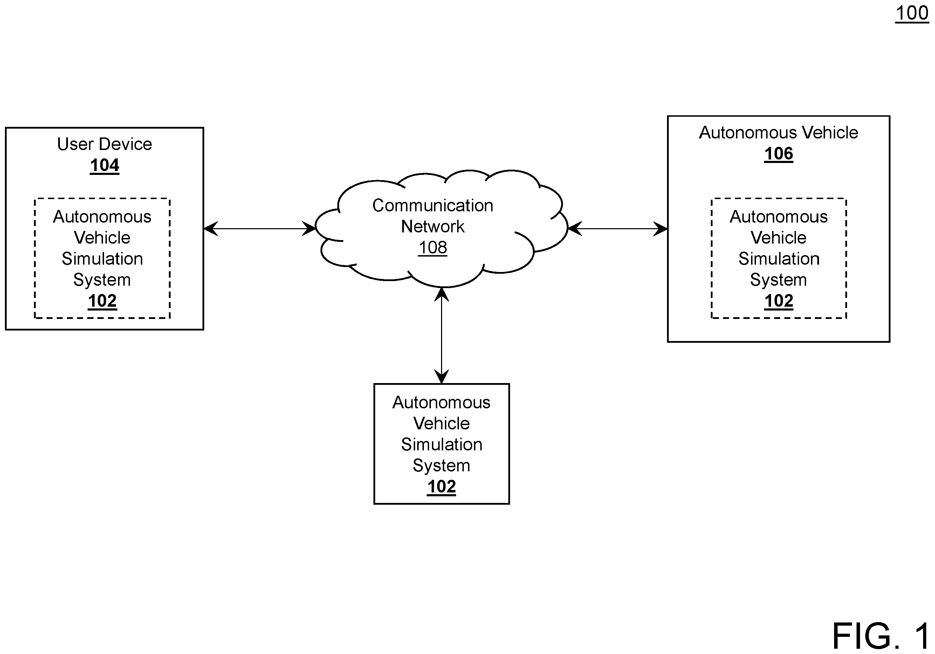

Referring now to FIG. 1, FIG. 1 is a diagram of an example environment 100 in which systems, methods, products, apparatuses, and/or devices described herein, may be implemented. As shown in FIG. 1, environment 100 may include autonomous vehicle simulation system 102, user device 104, autonomous vehicle 106, and communication network 108.

Autonomous vehicle simulation system 102 may include one or more devices capable of communicating with user device 104 and/or autonomous vehicle 106 via communication network 108. For example, autonomous vehicle simulation system 102 may include a computing device, such as a server, a group of servers, and/or other like devices.

User device 104 may include one or more devices capable of communicating with autonomous vehicle simulation system 102 and/or autonomous vehicle 106 via communication network 108. For example, autonomous vehicle simulation system 102 may include a computing device, such as a mobile device, a desktop computer, and/or other like devices. In some non-limiting embodiments, autonomous vehicle simulation system 102 may communicate with user device 104 via an application (e.g., a mobile application) stored on user device 104. In some non-limiting embodiments, user device 104 may include an image capture device (e.g., a camera, a stereo camera, etc.) and/or one or more sensors (e.g., a LiDAR sensor, a radio frequency identification (RFID) sensor, a light sensor, an image sensor, a laser sensor, a barcode reader, an audio sensor, etc.).

Autonomous vehicle 106 may include one or more devices capable of communicating with autonomous vehicle simulation system 102 and/or user device 104 via communication network 108. For example, autonomous vehicle 106 may include a computing device, such as a server, a group of servers, and/or other like devices. In some non-limiting embodiments, autonomous vehicle simulation system 102 may be a component of autonomous vehicle 106. In some non-limiting embodiments, user device 104 may be a component of autonomous vehicle 106.

Communication network 108 may include one or more wired and/or wireless networks. For example, communication network 108 may include a cellular network (e.g., a long-term evolution (LTE) network, a third generation (3G) network, a fourth generation (4G) network, a fifth generation (5G) network, a code division multiple access (CDMA) network, etc.), a public land mobile network (PLMN), a local area network (LAN), a wide area network (WAN), a metropolitan area network (MAN), a telephone network (e.g., the public switched telephone network (PSTN)), a private network, an ad hoc network, an intranet, the Internet, a fiber optic-based network, a cloud computing network, and/or the like, and/or a combination of these or other types of networks.

The number and arrangement of devices and systems shown in FIG. 1 is provided as an example. There may be additional devices and/or systems, fewer devices and/or systems, different devices and/or systems, or differently arranged devices and/or systems than those shown in FIG. 1. Furthermore, two or more devices and/or systems shown in FIG. 1 may be implemented within a single device and/or system, or a single device and/or system shown in FIG. 1 may be implemented as multiple, distributed devices and/or systems. For example, autonomous vehicle 106 may incorporate the functionality of autonomous vehicle simulation system 102 such that autonomous vehicle 106 can operate without communication to or from autonomous vehicle simulation system 102. Additionally or alternatively, a set of devices and/or systems (e.g., one or more devices or systems) of environment 100 may perform one or more functions described as being performed by another set of devices and/or systems of environment 100.

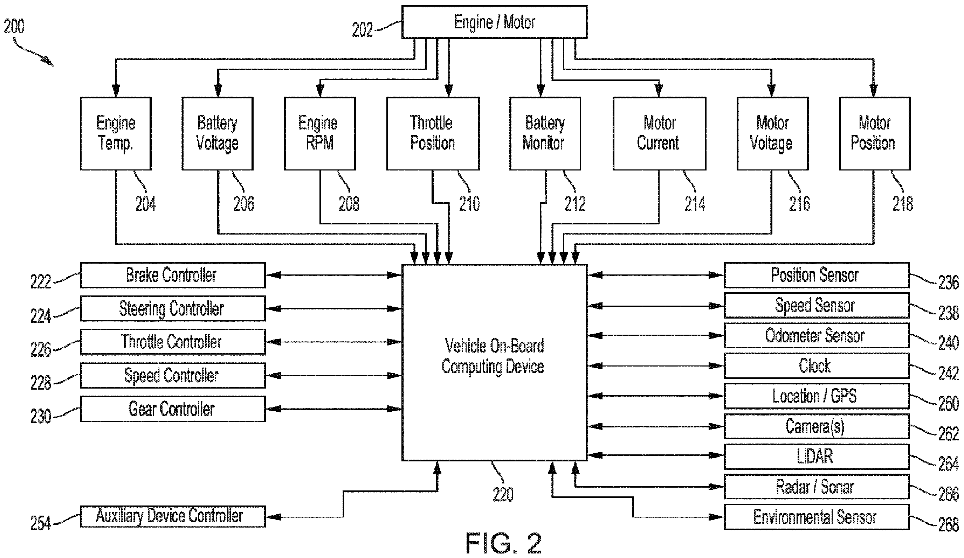

Referring now to FIG. 2, FIG. 2 is an illustration of an illustrative system architecture 200 for a vehicle. Autonomous vehicle 106 may include a same or similar system architecture as that of system architecture 200 shown in FIG. 2.

As shown in FIG. 2, system architecture 200 may include engine or motor 202 and various sensors 204-218 for measuring various parameters of the vehicle. In gas-powered or hybrid vehicles having a fuel-powered engine, the sensors may include, for example, engine temperature sensor 204, battery voltage sensor 206, engine Rotations Per Minute ("RPM") sensor 208, throttle position sensor 210, and/or a seat occupancy sensor (not shown). In an electric or hybrid vehicle, the vehicle may have an electric motor, and may have sensors, such as battery monitor sensor 212 (e.g., to measure current, voltage, and/or temperature of the battery), motor current sensor 214, motor voltage sensor 216, and/or motor position sensors 218, such as resolvers and encoders.

System architecture 200 may include operational parameter sensors, which may be common to both types of vehicles, and may include, for example: position sensor 236, such as an accelerometer, gyroscope, and/or inertial measurement unit; speed sensor 238; and/or odometer sensor 240. System architecture 200 may include clock 242 that are used to determine vehicle time during operation. Clock 242 may be encoded into vehicle on-board computing device 220. It may be a separate device or multiple clocks may be available.

System architecture 200 may include various sensors that operate to gather information about an environment in which the vehicle is operating and/or traveling. These sensors may include, for example: location sensor 260 (e.g., a Global Positioning System ("GPS") device); object detection sensors, such as one or more cameras 262; LiDAR sensor system 264; and/or radar and/or sonar system 266. The sensors may include environmental sensors 268, such as a precipitation sensor, an ambient temperature sensor, and/or an acoustic sensor (e.g., a microphone, a phased-array of microphones, and/or the like). The object detection sensors may enable system architecture 200 to detect objects that are within a given distance range of the vehicle in any direction, and environmental sensors 268 may collect data about environmental conditions within an area of operation and/or travel of the vehicle.

During operation of system architecture 200, information is communicated from the sensors of system architecture 200 to vehicle on-board computing device 220. Vehicle on-board computing device 220 analyzes the data captured by the sensors and optionally controls operations of the vehicle based on results of the analysis. For example, vehicle on-board computing device 220 may control: braking via brake controller 222; direction via steering controller 224; speed and acceleration via throttle controller 226 (e.g., in a gas-powered vehicle) or motor speed controller 228, such as a current level controller (e.g., in an electric vehicle); differential gear controller 230 (e.g., in vehicles with transmissions); and/or other controllers, such as auxiliary device controller 254.

Geographic location information may be communicated from location sensor 260 to vehicle on-board computing device 220, which may access a map of the environment including map data that corresponds to the location information to determine known fixed features of the environment, such as streets, buildings, stop signs, and/or stop/go signals. Captured images from cameras 262 and/or object detection information captured from sensors, such as LiDAR sensor system 264 is communicated from those sensors to vehicle on-board computing device 220. The object detection information and/or captured images are processed by vehicle on-board computing device 220 to detect objects in proximity to the vehicle. Any known or to be known technique for making an object detection based on sensor data and/or captured images can be used in the embodiments disclosed in the present disclosure.

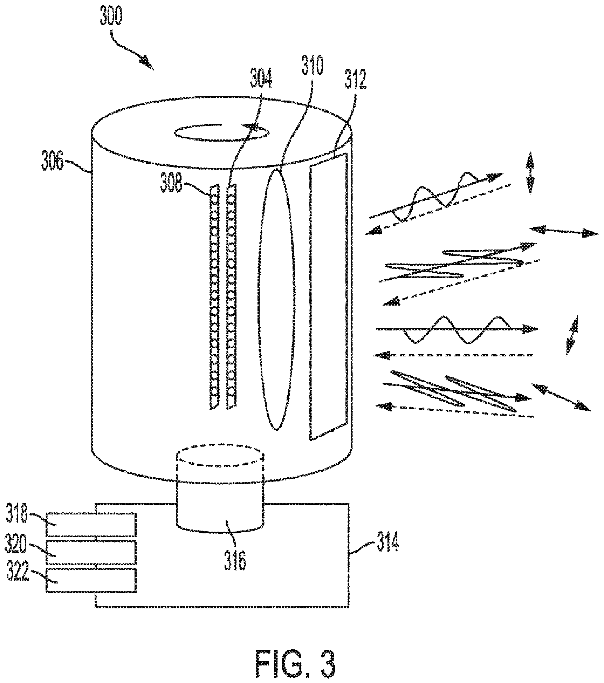

Referring now to FIG. 3, FIG. 3 is an illustration of an illustrative LiDAR system 300. LiDAR sensor system 264 of FIG. 2 may be the same as or substantially similar to LiDAR system 300.

As shown in FIG. 3, LiDAR system 300 may include housing 306, which may be rotatable 360° about a central axis, such as hub or axle 316. Housing 306 may include an emitter/receiver aperture 312 made of a material transparent to light (e.g., transparent to infrared light). Although a single aperture is shown in FIG. 3, non-limiting embodiments of the present disclosure are not limited in this regard. In other scenarios, multiple apertures for emitting and/or receiving light may be provided. Either way, LiDAR system 300 can emit light through one or more of aperture(s) 312 and receive reflected light back toward one or more of aperture(s) 312 as housing 306 rotates around the internal components. In an alternative scenario, the outer shell of housing 306 may be a stationary dome, at least partially made of a material that is transparent to light, with rotatable components inside of housing 306.

Inside the rotating shell or stationary dome is a light emitter system 304 that is configured and positioned to generate and emit pulses of light through aperture 312 or through the transparent dome of housing 306 via one or more laser emitter chips or other light emitting devices. Light emitter system 304 may include any number of individual emitters (e.g., 8 emitters, 64 emitters, 128 emitters, etc.). The emitters may emit light of substantially the same intensity or of varying intensities. The individual beams emitted by light emitter system 304 may have a well-defined state of polarization that is not the same across the entire array. As an example, some beams may have vertical polarization and other beams may have horizontal polarization. LiDAR system 300 may include light detector 308 containing a photodetector or array of photodetectors positioned and configured to receive light reflected back into the system. Light emitter system 304 and light detector 308 may rotate with the rotating shell, or light emitter system 304 and light detector 308 may rotate inside the stationary dome of housing 306. One or more optical element structures 310 may be positioned in front of light emitter system 304 and/or light detector 308 to serve as one or more lenses and/or waveplates that focus and direct light that is passed through optical element structure 310.

One or more optical element structures 310 may be positioned in front of a mirror to focus and direct light that is passed through optical element structure 310. As described herein below, LiDAR system 300 may include optical element structure 310 positioned in front of a mirror and connected to the rotating elements of LiDAR system 300 so that optical element structure 310 rotates with the mirror. Alternatively or in addition, optical element structure 310 may include multiple such structures (e.g., lenses, waveplates, etc.). In some non-limiting embodiments, multiple optical element structures 310 may be arranged in an array on or integral with the shell portion of housing 306.

In some non-limiting embodiments, each optical element structure 310 may include a beam splitter that separates light that the system receives from light that the system generates. The beam splitter may include, for example, a quarter-wave or half-wave waveplate to perform the separation and ensure that received light is directed to the receiver unit rather than to the emitter system (which could occur without such a waveplate as the emitted light and received light should exhibit the same or similar polarizations).

LiDAR system 300 may include power unit 318 to power light emitter system 304, motor 316, and electronic components. LiDAR system 300 may include analyzer 314 with elements, such as processor 322 and non-transitory computer-readable memory 320 containing programming instructions that are configured to enable the system to receive data collected by the light detector unit, analyze the data to measure characteristics of the light received, and generate information that a connected system can use to make decisions about operating in an environment from which the data was collected. Analyzer 314 may be integral with LiDAR system 300 as shown, or some or all of analyzer 314 may be external to LiDAR system 300 and communicatively connected to LiDAR system 300 via a wired and/or wireless communication network or link.

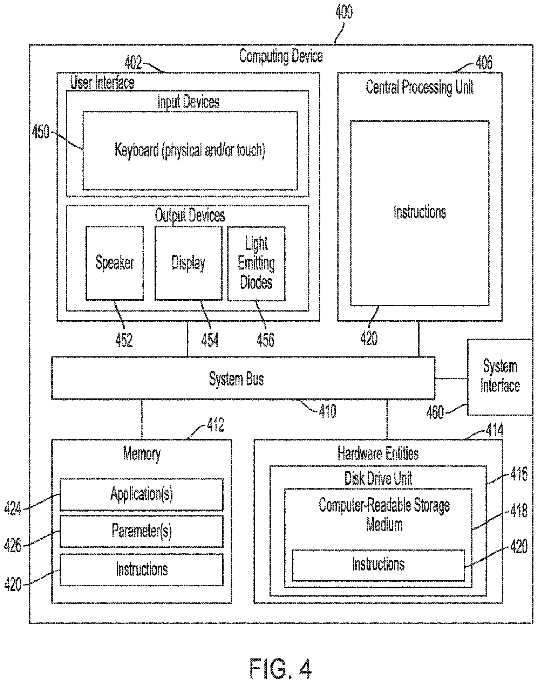

Referring now to FIG. 4, FIG. 4 is a diagram of an architecture for a computing device 400. Computing device 400 can correspond to one or more devices of (e.g., one or more devices of a system of) autonomous vehicle simulation system 102, user device 104, and/or one or more devices of autonomous vehicle 106 (e.g., one or more devices of system architecture 200, etc.). In some non-limiting embodiments, one or more devices of (e.g., one or more devices of a system of) autonomous vehicle simulation system 102, user device 104, and/or autonomous vehicle 106 (e.g., one or more devices of system architecture 200, etc.) can include at least one computing device 400 and/or at least one component of computing device 400.

The number and arrangement of components shown in FIG. 4 are provided as an example. In some non-limiting embodiments, computing device 400 may include additional components, fewer components, different components, or differently arranged components than those shown in FIG. 4. Additionally or alternatively, a set of components (e.g., one or more components) of computing device 400 may perform one or more functions described as being performed by another set of components of computing device 400.

As shown in FIG. 4, computing device 400 comprises user interface 402, Central Processing Unit ("CPU") 406, system bus 410, memory 412 connected to and accessible by other portions of computing device 400 through system bus 410, system interface 460, and hardware entities 414 connected to system bus 410. User interface 402 can include input devices and output devices, which facilitate user-software interactions for controlling operations of computing device 400. The input devices may include, but are not limited to, physical and/or touch keyboard 450. The input devices can be connected to computing device 400 via a wired and/or wireless connection (e.g., a Bluetooth^{®} connection). The output devices may include, but are not limited to, speaker 452, display 454, and/or light emitting diodes 456. System interface 460 is configured to facilitate wired and/or wireless communications to and from external devices (e.g., network nodes, such as access points, etc.).

At least some of hardware entities 414 may perform actions involving access to and use of memory 412, which can be a Random Access Memory ("RAM"), a disk drive, flash memory, a Compact Disc Read Only Memory ("CD-ROM") and/or another hardware device that is capable of storing instructions and data. Hardware entities 414 can include disk drive unit 416 comprising computer-readable storage medium 418 on which is stored one or more sets of instructions 420 (e.g., software code) configured to implement one or more of the methodologies, procedures, or functions described herein. Instructions 420, application(s) 424, and/or parameter(s) 426 can also reside, completely or at least partially, within memory 412 and/or within CPU 406 during execution and/or use thereof by computing device 400. Memory 412 and CPU 406 may include machine-readable media (e.g., non-transitory computer-readable media). The term "machine-readable media", as used herein, may refer to a single medium or multiple media (e.g., a centralized or distributed database, and/or associated caches and server) that store the one or more sets of instructions 420. The term "machine-readable media", as used herein, may refer to any medium that is capable of storing, encoding, or carrying a set of instructions 420 for execution by computing device 400 and that cause computing device 400 to perform any one or more of the methodologies of the present disclosure.

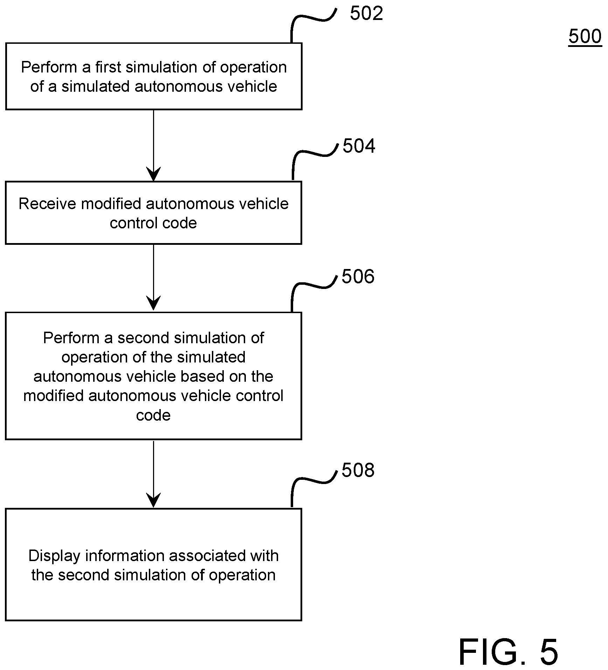

Referring now to FIG. 5, FIG. 5 is a flowchart of non-limiting embodiments of a process 500 for providing a comparison of results of simulations of operation of a simulated autonomous vehicle. In some non-limiting embodiments, one or more of the steps of process 500 may be performed (e.g., completely, partially, etc.) by autonomous vehicle simulation system 102 (e.g., one or more devices of autonomous vehicle simulation system 102, etc.). In some non-limiting embodiments, one or more of the steps of process 500 may be performed (e.g., completely, partially, etc.) by another device or a group of devices separate from or including autonomous vehicle simulation system 102, such as user device 104 and/or autonomous vehicle 106 (e.g., system architecture 200, etc.).

As shown in FIG. 5, at step 502, process 500 includes performing a first simulation of operation of a simulated autonomous vehicle. For example, autonomous vehicle simulation system 102 may perform the first simulation of operation of the simulated autonomous vehicle. In some non-limiting embodiments, a simulation of operation of the simulated autonomous vehicle is associated with a metric that measures performance of the simulated autonomous vehicle. For example, the simulation of operation of the simulated autonomous vehicle may result in a value of the metric being obtained.

In some non-limiting embodiments, a metric that measures performance of the simulated autonomous vehicle may include a metric associated with (e.g., that represents) a distance (e.g., a minimum distance, a maximum distance, an average distance, etc.) between the simulated autonomous vehicle and an actor (e.g., an object that is able to move during a simulation of operation) experienced during a simulation of operation; a metric associated with a number of halt events (e.g., an unplanned event that involves the simulated autonomous vehicle decreasing velocity and/or coming to a stop) experienced by the simulated autonomous vehicle during a simulation of operation, such as a number of halt events that exceed a threshold value (e.g., a threshold value of a number of halt events); a metric associated with an amount (e.g., a maximum amount, a minimum amount, an average amount, etc.) of longitudinal deceleration (e.g., longitudinal deceleration in m/s^2) experienced by the simulated autonomous vehicle during a simulation of operation; a metric associated with an amount (e.g., a maximum amount, a minimum amount, an average amount, etc.) of longitudinal negative jerk (e.g., longitudinal negative jerk in m/s^3) experienced by the simulated autonomous vehicle during a simulation of operation; a metric associated with an amount (e.g., a maximum amount, a minimum amount, an average amount, etc.) of lateral acceleration experienced by the simulated autonomous vehicle during a simulation of operation, a metric associated with an amount (e.g., a maximum amount, a minimum amount, an average amount, etc.) of lateral jerk (e.g., lateral jerk in m/s^3) experienced by the simulated autonomous vehicle during a simulation of operation, such as a number of times an amount of lateral jerk satisfied a threshold value (e.g., a threshold value of lateral jerk) during the simulation of operation; a metric associated with a number of times the simulated autonomous vehicle planned to stop during a simulation of operation, such as a number of times the simulated autonomous vehicle planned to stop due to a region of likely intersection (ROLI), and/or a number of times the simulated autonomous vehicle planned to stop due to a contingency; and/or a metric associated with a number of times the simulated autonomous vehicle planned to change a trajectory (e.g., change a trajectory in consecutive cycles) during a simulation of operation.

Additionally or alternatively, the metric that measures performance of the simulated autonomous vehicle may include a metric associated with a duration of a simulation of operation, such as an amount of time (e.g., an amount of time measured in simulation time and not in real time) for the simulated autonomous vehicle to reach a destination; a metric associated with an amount of time (e.g., an amount of time measured in real time) to perform (e.g., run) a simulation of operation; a metric associated with an amount of time for computing one or more additional metrics that measure performance of the simulated autonomous vehicle; metric associated with a size of a debug log associated with a version of software code that was used during a simulation of operation; and/or a metric associated with a size of an entire log associated with a version of software code that was used during a simulation of operation.

In some non-limiting embodiments, a simulation of operation of a simulated autonomous vehicle may include a test scenario that provides for operating a simulated autonomous vehicle based on the autonomous vehicle control code in a manner so that a value of a metric that measures performance of the simulated autonomous vehicle can be obtained. A test scenario may include a scenario to determine whether the autonomous vehicle control code allows the simulated autonomous vehicle to pass or fail a test associated with the metric. For example, a test scenario may include a scenario for operating the simulated autonomous vehicle along a predetermined route based on the autonomous vehicle control code to determine whether the simulated autonomous vehicle passes or fails a test associated with the metric. In some non-limiting embodiments, the test may measure whether a value of the metric that results from the test scenario satisfies a threshold (e.g., a threshold associated with a maximum value of the metric, a threshold associated with a minimum value of the metric, etc.) while the simulated autonomous vehicle operates along the predetermined route based on the autonomous vehicle control code.

In some non-limiting embodiments, autonomous vehicle simulation system 102 may perform the first simulation of operation of the simulated autonomous vehicle based on (e.g., using) first autonomous vehicle control code. In some non-limiting embodiments, the first autonomous vehicle control code may include software code (e.g., a first version of software code) associated with controlling operations of the simulated autonomous vehicle. For example, the first autonomous vehicle control code may include a version of software code associated with controlling operations of the simulated autonomous vehicle during the first simulation of operation.

In some non-limiting embodiments, autonomous vehicle simulation system 102 may perform a test scenario based on the first autonomous vehicle control code to determine whether the simulated autonomous vehicle will pass or fail a test associated with the metric. For example, autonomous vehicle simulation system 102 may perform the test scenario based on the first autonomous vehicle control code to provide a value of a metric that results from the test scenario. Autonomous vehicle simulation system 102 may compare the value of the metric to a threshold associated with a test to determine whether the simulated autonomous vehicle will pass or fail the test. In one example, if autonomous vehicle simulation system 102 determines that the value of the metric satisfies the threshold associated with the test, autonomous vehicle simulation system 102 may determine that the simulated autonomous vehicle passed the test. In another example, if autonomous vehicle simulation system 102 determines that the value of the metric does not satisfy the threshold associated with the test, autonomous vehicle simulation system 102 may determine that the simulated autonomous vehicle failed the test. In yet another example, if autonomous vehicle simulation system 102 determines that the value of the metric satisfies the threshold associated with the test, autonomous vehicle simulation system 102 may determine that the simulated autonomous vehicle failed the test. In another example, if autonomous vehicle simulation system 102 determines that the value of the metric does not satisfy the threshold associated with the test, autonomous vehicle simulation system 102 may determine that the simulated autonomous vehicle passed the test.

In some non-limiting embodiments, autonomous vehicle simulation system 102 may receive the first autonomous vehicle control code from user device 104. In some non-limiting embodiments, autonomous vehicle simulation system 102 may obtain (e.g., retrieve) the first autonomous vehicle control code from a data structure (e.g., a database) associated with autonomous vehicle simulation system 102. In some non-limiting embodiments, autonomous vehicle simulation system 102 and/or user device 104 may generate the first autonomous vehicle control code.

In some non-limiting embodiments, autonomous vehicle simulation system 102 may determine whether a value of a metric that resulted from the first simulation of operation based on the first autonomous vehicle control code satisfies a threshold (e.g., a threshold value of a metric). For example, autonomous vehicle simulation system 102 may compare the value of a metric that resulted from the first simulation of operation to the threshold and determine whether the value of the metric satisfies the threshold based on comparing the value of the metric to the threshold. In some non-limiting embodiments, autonomous vehicle simulation system 102 may display the value of the metric that resulted from the first simulation of operation in a user interface.

In some non-limiting embodiments, autonomous vehicle simulation system 102 may perform a plurality of additional simulations of operation of the simulated autonomous vehicle. Each additional simulation of operation may be performed based on additional autonomous vehicle control code. In some non-limiting embodiments, the additional autonomous vehicle control code may include an additional version of software code (e.g., an additional version of software code that is different from a first version) associated with controlling operations of the simulated autonomous vehicle.

In some non-limiting embodiments, autonomous vehicle simulation system 102 may display, in a user interface, a trend graph of a value of a metric that resulted from each additional simulation of the plurality of additional simulations of operation of the simulated autonomous vehicle. In some non-limiting embodiments, the trend graph may be based on a time interval during which the plurality of additional simulations of operation of the simulated autonomous vehicle were performed.

As shown in FIG. 5, at step 504, process 500 includes receiving modified autonomous vehicle control code. For example, autonomous vehicle simulation system 102 may receive the modified autonomous vehicle control code. In some non-limiting embodiments, the modified autonomous vehicle control code may include a version of software code associated with controlling operations of the simulated autonomous vehicle that has been modified from a prior version of the software code. In some non-limiting embodiments, the modified autonomous vehicle control code may include a version (e.g., a second version) of the software code associated with controlling operations of the simulated autonomous vehicle that is a modification of a version (e.g., a first version) of the software code associated with controlling operations of the simulated autonomous vehicle during the first simulation of operation of the simulated autonomous vehicle.

In some non-limiting embodiments, autonomous vehicle simulation system 102 may receive the modified autonomous vehicle control code from user device 104. In some non-limiting embodiments, autonomous vehicle simulation system 102 may obtain the modified autonomous vehicle control code from a data structure associated with autonomous vehicle simulation system 102. In some non-limiting embodiments, autonomous vehicle simulation system 102 and/or user device 104 may generate the modified autonomous vehicle control code.

As shown in FIG. 5, at step 506, process 500 includes performing a second simulation of operation of the simulated autonomous vehicle. For example, autonomous vehicle simulation system 102 may perform the second simulation of operation of the simulated autonomous vehicle based on the modified autonomous vehicle control code. In some non-limiting embodiments, autonomous vehicle simulation system 102 may perform the second simulation of operation of the simulated autonomous vehicle in the same or similar fashion as performing the first simulation of operation (e.g., as described in step 502).

In some non-limiting embodiments, autonomous vehicle simulation system 102 may perform the second simulation of operation of the simulated autonomous vehicle based on the modified (e.g., second) autonomous vehicle control code. In some non-limiting embodiments, autonomous vehicle simulation system 102 may determine whether a value of a metric that resulted from the second simulation of operation based on the modified autonomous vehicle control code satisfies a threshold (e.g., a threshold value of a metric). For example, autonomous vehicle simulation system 102 may compare the value of a metric that resulted from the second simulation of operation to the threshold and determine whether the value of the metric satisfies the threshold based on comparing the value of the metric to the threshold.

In some non-limiting embodiments, autonomous vehicle simulation system 102 may perform a plurality of additional simulations of operation of the simulated autonomous vehicle before performing the second simulation of operation.

In some non-limiting embodiments, autonomous vehicle simulation system 102 may perform a test scenario based on the modified autonomous vehicle control code to determine whether the simulated autonomous vehicle will pass or fail a test associated with a metric. For example, autonomous vehicle simulation system 102 may perform the test scenario based on the modified autonomous vehicle control code to provide a value of the metric that results from the test scenario. Autonomous vehicle simulation system 102 may compare the value of the metric to a threshold associated with a test to determine whether the simulated autonomous vehicle will pass or fail the test. In one example, if autonomous vehicle simulation system 102 determines that the value of the metric satisfies the threshold associated with the test, autonomous vehicle simulation system 102 may determine that the simulated autonomous vehicle passed the test. In another example, if autonomous vehicle simulation system 102 determines that the value of the metric does not satisfy the threshold associated with the test, autonomous vehicle simulation system 102 may determine that the simulated autonomous vehicle failed the test. In yet another example, if autonomous vehicle simulation system 102 determines that the value of the metric satisfies the threshold associated with the test, autonomous vehicle simulation system 102 may determine that the simulated autonomous vehicle failed the test. In another example, if autonomous vehicle simulation system 102 determines that the value of the metric does not satisfy the threshold associated with the test, autonomous vehicle simulation system 102 may determine that the simulated autonomous vehicle passed the test.

As shown in FIG. 5, at step 508, process 500 includes display information associated with the second simulation of operation. For example, autonomous vehicle simulation system 102 may display the information associated with the second simulation of operation. In some non-limiting embodiments, autonomous vehicle simulation system 102 may display a value of a metric that resulted from the second simulation of operation in a user interface. In some non-limiting embodiments, autonomous vehicle simulation system 102 may display an indication that the value of the metric that resulted from the second simulation of operation is different from a value of the metric that resulted from the first simulation of operation in the user interface. In some non-limiting embodiments, autonomous vehicle simulation system 102 may display an indication that the value of the metric that resulted from the second simulation of operation is different from values of the metric that resulted from additional simulations of operation in the user interface.

In some non-limiting embodiments, autonomous vehicle simulation system 102 may display an indication that the value of the metric that resulted from the second simulation of operation satisfies a threshold (e.g., a threshold value associated with the metric) in the user interface, based on determining that the value of the metric that resulted from the second simulation of operation satisfies the threshold. In some non-limiting embodiments, autonomous vehicle simulation system 102 may display a maximum value and/or a minimum value of the metric that resulted from the second simulation of operation in the user interface. In some non-limiting embodiments, autonomous vehicle simulation system 102 may display an amount by which the value of the metric that resulted from the second simulation of operation is different than the value of the metric that resulted from the first simulation of operation. In some non-limiting embodiments, autonomous vehicle simulation system 102 may display an amount by which the value of the metric that resulted from the second simulation of operation is different than values of the metric that resulted from additional simulations of operation. In some non-limiting embodiments, autonomous vehicle simulation system 102 may display an indication associated with a test scenario of whether the simulated autonomous vehicle passed or failed a test associated with a metric.

In some non-limiting embodiments, autonomous vehicle simulation system 102 may provide the operational code to autonomous vehicle 106 for operating the autonomous vehicle in a real environment. For example, autonomous vehicle simulation system 102 may provide the operational code to autonomous vehicle 106 where the operational code is based on the modified autonomous vehicle control code. In some non-limiting embodiments, autonomous vehicle simulation system 102 may generate the operational code based on the modified autonomous vehicle control code when the modified autonomous vehicle control code has progressed through a plurality of stages of development associated with developing the operational code. In some non-limiting embodiments, autonomous vehicle 106 may operate in the real environment based on the operational code.

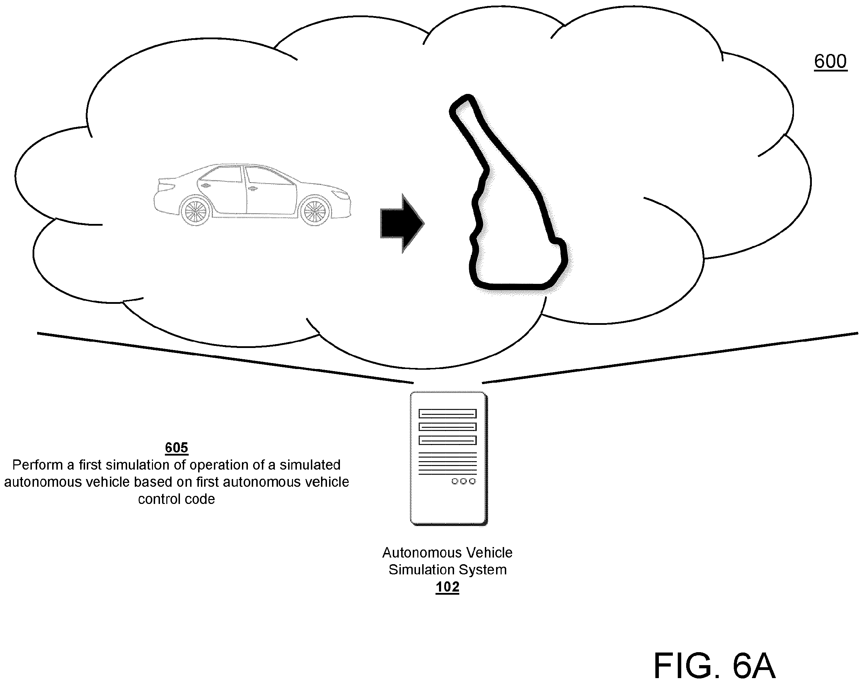

Referring now to FIGS. 6A-6E, FIGS. 6A-6E are diagrams of an implementation 600 of a process (e.g., process 500) for providing a comparison of results of simulations of operation of a simulated autonomous vehicle.

As shown by reference number 605 in FIG. 6A, autonomous vehicle simulation system 102 may perform a first simulation of operation of a simulated autonomous vehicle based on first autonomous vehicle control code. In some non-limiting embodiments, the first simulation may include a plurality of test scenarios that provides for operating the simulated autonomous vehicle based on the first autonomous vehicle control code in a manner so that values of a metric that measures performance of the simulated autonomous vehicle can be obtained. Each test scenario may include a scenario to determine whether the autonomous vehicle control code allows the simulated autonomous vehicle to pass or fail a test associated with the metric. In some non-limiting embodiments, the first autonomous vehicle control code may include a first version of software code associated with controlling operations of the simulated autonomous vehicle during the first simulation of operation.

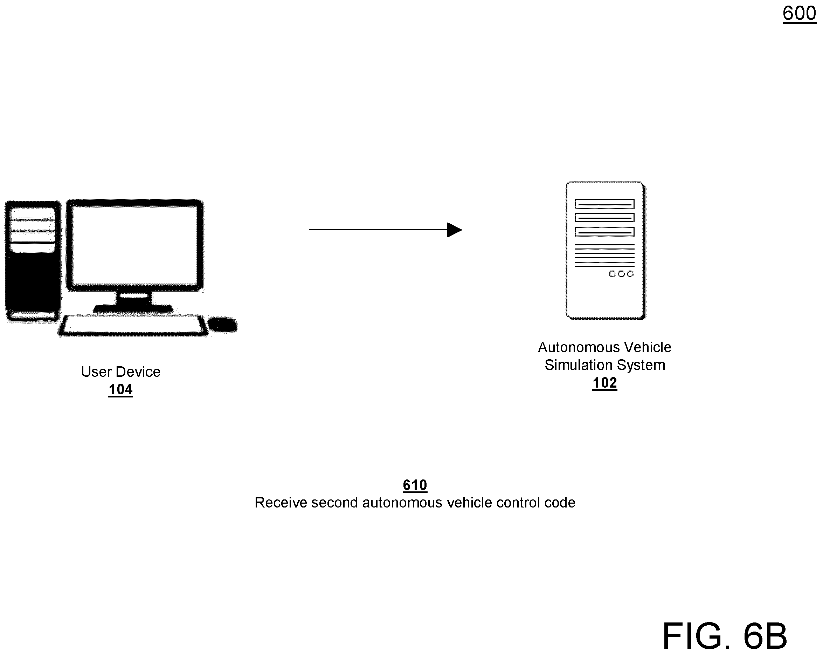

As shown by reference number 610 in FIG. 6B, autonomous vehicle simulation system 102 may receive second autonomous vehicle control code from user device 104. In some non-limiting embodiments, the second autonomous vehicle control code may include a second version of software code associated with controlling operations of the simulated autonomous vehicle that has been modified from the first version of software code associated with controlling operations of the simulated autonomous vehicle during the first simulation of operation.

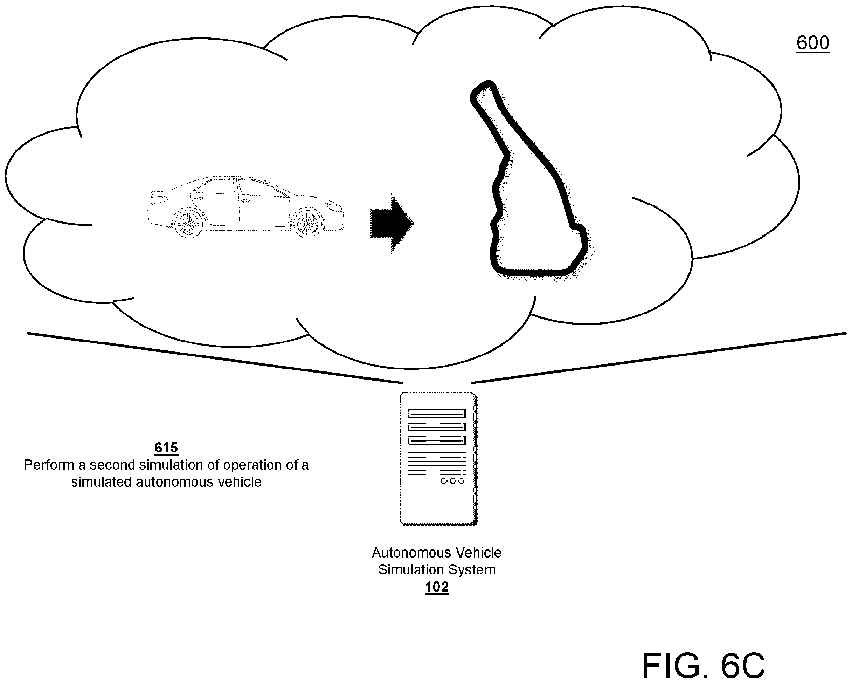

As shown by reference number 615 in FIG. 6C, autonomous vehicle simulation system 102 may perform a second simulation of operation of a simulated autonomous vehicle. In some non-limiting embodiments, the second simulation of operation may include the plurality of test scenarios that provides for operating the simulated autonomous vehicle based on the second autonomous vehicle control code in a manner so that values of a metric that measures performance of the simulated autonomous vehicle can be obtained.

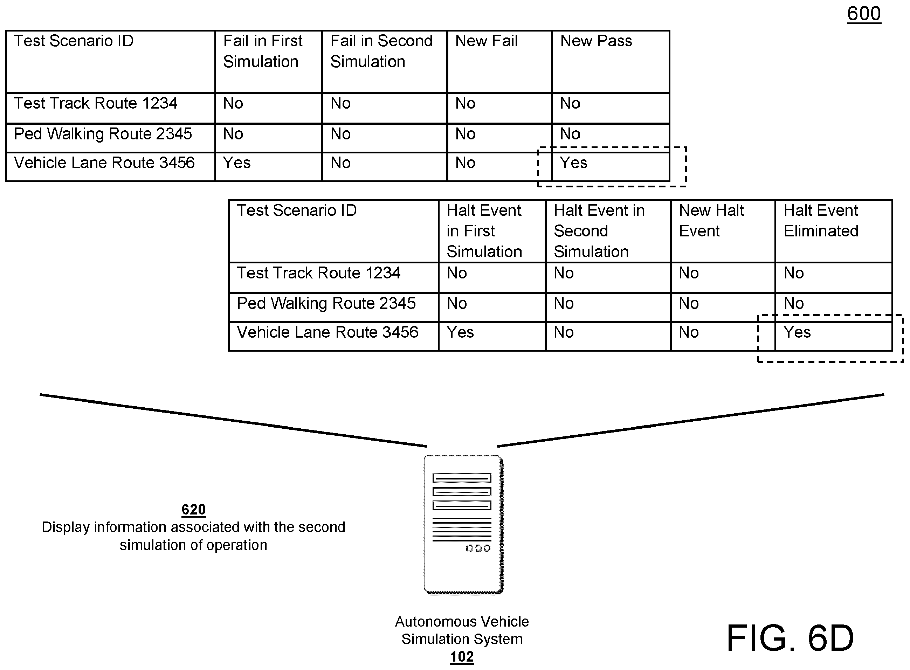

As shown by reference number 620 in FIG. 6D, autonomous vehicle simulation system 102 may display information associated with the second simulation of operation. In some non-limiting embodiments, autonomous vehicle simulation system 102 may display a plurality of tables that show an identifier (ID) of a test scenario of the first simulation and the second simulation along with indications of whether the simulated autonomous vehicle passed or failed a test associated with a metric in test scenarios of the first simulation and test scenarios of the second simulation. As further shown in FIG. 6D, the metric may include a measure of whether a halt event was experienced during a simulation of operation. In the tables shown in FIG. 6D, a halt event was experienced during a test scenario of the first simulation having a test scenario ID of "Vehicle Lane Route 3456", but a halt event was not experienced during the same test scenario of the second simulation.

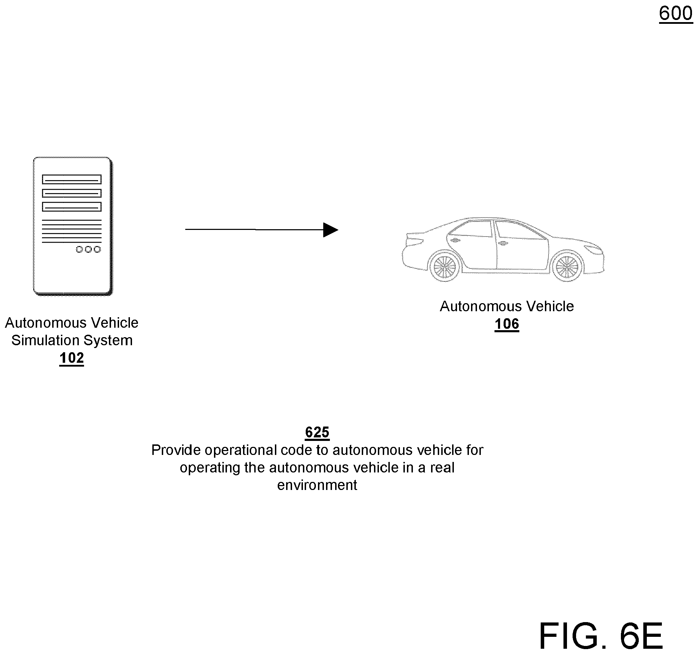

As shown by reference number 625 in FIG. 6E, autonomous vehicle simulation system 102 may provide the operational code to autonomous vehicle 106 for operating the autonomous vehicle in a real environment. In some non-limiting embodiments, the operational code may be based on the second autonomous vehicle control code. In some non-limiting embodiments, autonomous vehicle simulation system 102 may generate the operational code based on the second autonomous vehicle control code when the second autonomous vehicle control code has progressed through a plurality of stages of development associated with developing the operational code. In some non-limiting embodiments, autonomous vehicle 106 may operate in the real environment based on the operational code.

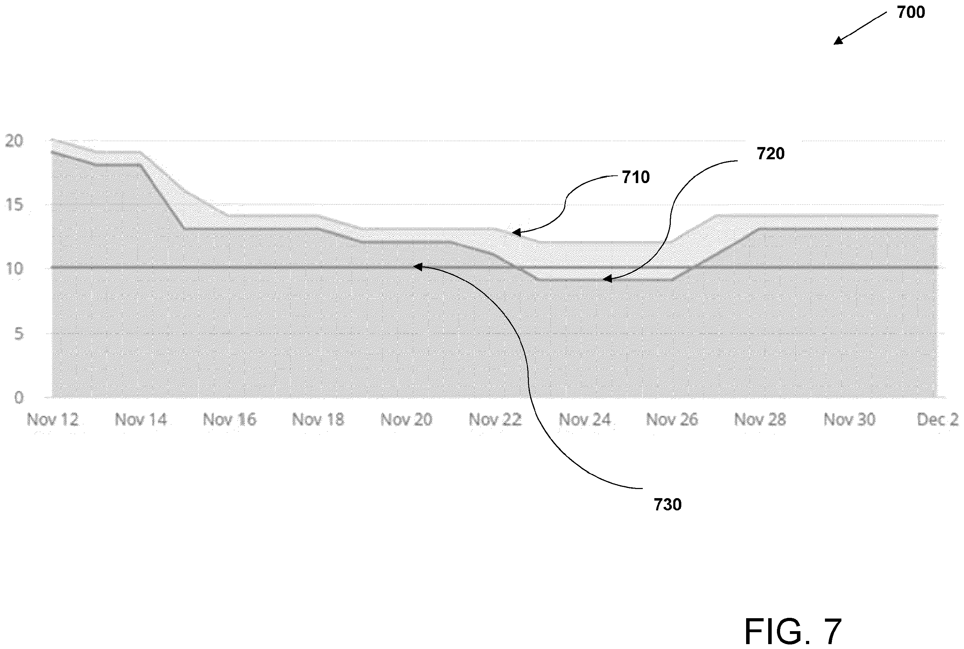

Referring now to FIG. 7, FIG. 7 is a diagram of trend graph 700 of results of simulations of operation of a simulated autonomous vehicle. As shown in FIG. 7, trend graph 700 includes first trend line 710 that indicates values of a first metric that measures performance of a simulated autonomous vehicle during a time interval, which resulted from a plurality of simulations of operation of the simulated autonomous vehicle that were performed during the time interval based on the autonomous vehicle control code. As further shown in FIG. 7, trend graph 700 includes second trend line 720 that indicates values of a second metric that measures performance of a simulated autonomous vehicle during the time interval, which resulted from the plurality of simulations of operation of the simulated autonomous vehicle that were performed during the time interval based on the autonomous vehicle control code. As further shown in FIG. 7, trend graph 700 includes line 730 that indicates a value of a metric (e.g., a value of the first metric or a value of the second metric), which resulted from a simulation (e.g., a second simulation) of operation of the simulated autonomous vehicle that was performed after the simulations associated with trend lines 710 and 720, based on modified autonomous vehicle control code. In some non-limiting embodiments, autonomous vehicle simulation system 102 may display an alert based on determining that a difference between line 730 and trend line 710 or trend line 720 satisfies a threshold.

Although embodiments have been described in detail for the purpose of illustration and description, it is to be understood that such detail is solely for that purpose and that embodiments are not limited to the disclosed embodiments, but, on the contrary, are intended to cover modifications and equivalent arrangements that are within the spirit and scope of the appended claims. For example, it is to be understood that the present disclosure contemplates that, to the extent possible, one or more features of any embodiment or aspect can be combined with one or more features of any other embodiment or aspect. In fact, any of these features can be combined in ways not specifically recited in the claims and/or disclosed in the specification. Although each dependent claim listed below may directly depend on only one claim, the disclosure of possible implementations includes each dependent claim in combination with every other claim in the claim set.

## Claims

1. A system comprising at least one processor being configured to:
receive first autonomous vehicle control code, wherein the first autonomous vehicle control code comprises a first version of software code associated with controlling operations of a simulated autonomous vehicle;
perform a first simulation of operation of the simulated autonomous vehicle based on the first autonomous vehicle control code, wherein the first simulation of operation is associated with one or more metrics that measure performance of the simulated autonomous vehicle;
receive second autonomous vehicle control code, wherein the second autonomous vehicle control code comprises a second version of software code associated with controlling operations of the simulated autonomous vehicle, wherein the second version of software code associated with controlling operations of the simulated autonomous vehicle comprises a modification of the first version of software code associated with controlling operations of the simulated autonomous vehicle;
perform a second simulation of operation of the simulated autonomous vehicle based on the second autonomous vehicle control code, wherein the second simulation of operation is associated with the one or more metrics that measure performance of the simulated autonomous vehicle; and
display an indication, in a user interface, that one or more second values of the one or more metrics that resulted from the second simulation of operation are different from the one or more first values of the one or more metrics that resulted from the first simulation of operation.

2. The system of claim 1, wherein the at least one processor is further configured to:
display the one or more first values of the one or more metrics that resulted from the first simulation of operation in the user interface; and
display one or more second values of the one or more metrics that resulted from the second simulation of operation in the user interface.

3. The system of claim 1 or 2, wherein the at least one processor is further configured to:
determine whether the one or more second values of the one or more metrics that resulted from the second simulation of operation satisfy one or more thresholds; and
display an indication, in the user interface, that the one or more second values of the one or more metrics that resulted from the second simulation of operation satisfy the one or more thresholds based on determining that the one or more second values of the one or more metrics that resulted from the second simulation of operation satisfy the one or more thresholds.

4. The system of any of claims 1 to 3, wherein the one or more metrics that measure performance of the simulated autonomous vehicle comprise:
a metric associated with a minimum distance between the simulated autonomous vehicle and an actor experienced during a simulation of operation;
a metric associated with a number of halt events experienced by the simulated autonomous vehicle during a simulation of operation;
a metric associated with an amount of longitudinal deceleration experienced by the simulated autonomous vehicle during a simulation of operation;
a metric associated with an amount of longitudinal negative jerk experienced by the simulated autonomous vehicle during a simulation of operation;
a metric associated with an amount of lateral acceleration experienced by the simulated autonomous vehicle during a simulation of operation;
a metric associated with an amount of lateral jerk experienced by the simulated autonomous vehicle during a simulation of operation;
a metric associated with a number of times the simulated autonomous vehicle planned to stop;
a metric associated with a number of times the simulated autonomous vehicle planned to change a trajectory; or
any combination thereof.

5. The system of any of claims 1 to 4, wherein the at least one processor is further configured to:
provide operational code to an autonomous vehicle for operating the autonomous vehicle in a real environment, wherein the operational code is based on the second autonomous vehicle control code and operate the autonomous vehicle in the real environment based on the operational code; and/or
display an amount by which the one or more second values of the one or more metrics are different than the one or more first values of the one or more metrics; and/or
display one or more maximum values of the one or more metrics that resulted from the second simulation of operation in the user interface.

6. The system of any of claims 1 to 5, wherein the at least one processor is further configured to:
perform a plurality of additional simulations of operation of the simulated autonomous vehicle, wherein each additional simulation of operation is performed based on additional autonomous vehicle control code, wherein the additional autonomous vehicle control code comprises an additional version of software code associated with controlling operations of the simulated autonomous vehicle;
display, in the user interface, a trend graph of values of the one or more metrics that resulted from the plurality of additional simulations of operation of the simulated autonomous vehicle; and
display an indication of the one or more second values of the one or more metrics that resulted from the second autonomous vehicle control code in comparison to the trend graph.

7. A computer program product, or a computer-readable medium storing the computer program, comprising instructions that, when executed by at least one processor, cause the at least one processor to:
receive first autonomous vehicle control code, wherein the first autonomous vehicle control code comprises a first version of software code associated with controlling operations of a simulated autonomous vehicle;
perform a first simulation of operation of the simulated autonomous vehicle based on the first autonomous vehicle control code, wherein the first simulation of operation is associated with one or more metrics that measure performance of the simulated autonomous vehicle;
receive second autonomous vehicle control code, wherein the second autonomous vehicle control code comprises a second version of software code associated with controlling operations of the simulated autonomous vehicle, wherein the second version of software code associated with controlling operations of the simulated autonomous vehicle comprises a modification of the first version of software code associated with controlling operations of the simulated autonomous vehicle;
perform a second simulation of operation of the simulated autonomous vehicle based on the second autonomous vehicle control code, wherein the second simulation of operation is associated with the one or more metrics that measure performance of the simulated autonomous vehicle; and
display an indication, in a user interface, that one or more second values of the one or more metrics that resulted from the second simulation of operation are different from the one or more first values of the one or more metrics that resulted from the first simulation of operation.

8. The computer program product or the computer-readable medium of claim 7, wherein the instructions further cause the at least one processor to:
display the one or more first values of the one or more metrics that resulted from the first simulation of operation in the user interface; and
display one or more second values of the one or more metrics that resulted from the second simulation of operation in the user interface.

9. The computer program product or the computer-readable medium of claim 7 or 8, wherein the instructions further cause the at least one processor to:
determine whether the one or more second values of the one or more metrics that resulted from the second simulation of operation satisfy one or more thresholds; and
display an indication, in the user interface, that the one or more second values of the one or more metrics that resulted from the second simulation of operation satisfy the one or more thresholds based on determining that the one or more second values of the one or more metrics that resulted from the second simulation of operation satisfy the one or more thresholds.

10. The computer program product or the computer-readable medium of any of claims 7 to 9, wherein the instructions further cause the at least one processor to:
provide operational code to an autonomous vehicle for operating the autonomous vehicle in a real environment, wherein the operational code is based on the second autonomous vehicle control code, and operate the autonomous vehicle in the real environment based on the operational code; and/or
display one or more maximum values of the one or more metrics that resulted from the second simulation of operation in the user interface.

11. The computer program product or the computer-readable medium of any of claims 7 to 10, wherein the instructions further cause the at least one processor to:
perform a plurality of additional simulations of operation of the simulated autonomous vehicle, wherein each additional simulation of operation is performed based on an additional version of software code associated with controlling operations of the simulated autonomous vehicle;
display, in the user interface, a trend graph of values of the one or more metrics that resulted from the plurality of additional simulations of operation of the simulated autonomous vehicle; and
display an indication of the one or more second values of the one or more metrics that resulted from the second autonomous vehicle control code in comparison to the trend graph.

12. A computer-implemented method, comprising:
performing, with at least one processor, a first simulation of operation of a simulated autonomous vehicle based on first autonomous vehicle control code, wherein the first simulation of operation is associated with one or more metrics that measure performance of the simulated autonomous vehicle;
receiving, with the at least one processor, second autonomous vehicle control code, wherein the second autonomous vehicle control code comprises a second version of software code associated with controlling operations of the simulated autonomous vehicle, wherein the second version of software code associated with controlling operations of the simulated autonomous vehicle comprises a modification of the first version of software code associated with controlling operations of the simulated autonomous vehicle;
performing, with the at least one processor, a second simulation of operation of the simulated autonomous vehicle based on the second autonomous vehicle control code, wherein the second simulation of operation is associated with the one or more metrics that measure performance of the simulated autonomous vehicle; and
displaying, with the at least one processor, an indication, in a user interface, that one or more second values of the one or more metrics that resulted from the second simulation of operation are different from the one or more first values of the one or more metrics that resulted from the first simulation of operation.

13. The method of claim 12, further comprising:
determining whether the one or more second values of the one or more metrics that resulted from the second simulation of operation satisfy one or more thresholds; and
displaying an indication, in the user interface, that the one or more second values of the one or more metrics that resulted from the second simulation of operation satisfy the one or more thresholds based on determining that the one or more second values of the one or more metrics that resulted from the second simulation of operation satisfy the one or more thresholds.

14. The method of claim 12 or 13, further comprising:
providing operational code to an autonomous vehicle for operating the autonomous vehicle in a real environment, wherein the operational code is based on the second autonomous vehicle control code; and
operating the autonomous vehicle in the real environment based on the operational code.

15. The method of any of claims 12 to 14, further comprising:
performing a plurality of additional simulations of operation of the simulated autonomous vehicle before performing the second simulation, wherein each additional simulation of operation is performed based on an additional version of software code associated with controlling operations of the simulated autonomous vehicle;
displaying, in the user interface, a trend graph of values of the one or more metrics that resulted from the plurality of additional simulations of operation of the simulated autonomous vehicle; and
displaying an indication of the one or more second values of the one or more metrics that resulted from the second autonomous vehicle control code in comparison to the trend graph.
